# EUROPEAN PATENT APPLICATION

(11) **EP 1 777 997 A1**
(43) Date of publication of application: **25.04.2007**
(21) Application number: 05077397.7
(22) Date of filing: 18.10.2005
(51) Int. Cl.: H05K 1/09

(54) **Method for preparing a conductive circuit device**

(71) Applicant: Nederlandse Organisatie voor toegepast-natuurwetenschappelijk Onderzoek TNO, 2628 VK Delft (NL)
(72) Inventor: Hackert, Jürgen, 08223 Grünbach (DE)
(74) Representative: Winckels, Johannes Hubertus F.

(57) **Abstract**

The invention provides method for preparing a conductive device comprising the steps of:
(a) providing a non-conductive substrate layer;
(b) applying a pattern of an ink on a surface of the substrate layer, which ink comprises a first metal;
(c) depositing a second metal on the ink pattern obtained in step (b); and
(d) applying a third metal on the second metal by means of electrodeposition.

The invention further provides a conductive device obtainable by said method.

## Description

The present invention relates to a method for preparing a conductive device and a conductive device obtainable with said method.

Conductive devices are used in broad variety of applications including, for instance, aeriels and tracking and tracing devices.

Conventionally, conductive devices for such applications are made by printing a pattern of a metal rich ink on a ceramic substrate layer and subsequently fusing the pattern of the ink obtained at an elevated temperature. A considerable drawback of such a preparation method is that the sharpness of the conductive track obtained leaves much room for improvement. The width of the track lines is relatively broad and only a relative small number of track lines can be applied onto the conductive device. In addition, the conductivity of the track does not approach the conductivity of the metal applied as such.

Object of the present invention is to provide a method which enables the preparation of improved conductive devices.

Surprisingly, it has now been found that such improved conductive devices can be prepared by using an ink technology in combination with an electroless deposition step and an electrodeposition step.

Accordingly, the present invention relates to a method for preparing a conductive device comprising the steps of:
(a) providing a non-conductive substrate layer;
(b) applying a pattern of an ink on a surface of the substrate layer, which ink comprises a first metal;
(c) depositing a second metal on the ink pattern obtained in step (b); and
(d) applying a third metal on the second metal by means of electrodeposition.

The conductive devices prepared in accordance with the present invention are very attractive since they have much sharper, straighter and more narrow track lines when compared to conductive devices obtained with the conventional process described hereinabove. Consequently, the conductive devices obtained in accordance with the present invention can contain a much larger number of conductive tracks.

Suitably, the ink to be used in step (b) comprises metal particles and/or a metal composition suitable to catalyse electroless deposition. Electrolessdeposition uses a redox reaction to deposit metal on a catalytic object without applying an external electric current. The reaction involves a reduction of a complexed metal, typically Cu, Ni, Ag, Au, Co or Sn or alloys thereof, using a reducing agent, e.g. formaldehyde, dimethylaminoborane, hypophosphite, hydrazine or boriumhydride.

When the ink comprises metal particles that are suitable for electroless deposition, the metal particles are preferably metal nanoparticles.

In case the ink comprises a metal composition which is suitable for electroless deposition, the metal composition comprises a metal salt and/or an organometallic complex. The metal ion has to be reduced to the zero charge, metallic state, to be able to act as a catalyst. Hence, after printing of the ink, the metal salt or organometallic complex has to react either with a reducing agent or break down under the influence of radiation such as heat or light. Suitable examples of metal salts include but are not limited to metal chlorides, nitrates, sulfates, phospates, nitrates, bromates and acetates Suitable examples of organometallic complexes are based on palladium, iron, cobalt , gold, silver, nickel or copper.

Although a mixture of metal particles and a metal composition can be used, preferably the ink comprises metal particles or a metal salt. More preferably, the ink comprises a metal salt. Such metal salt preferably comprises palladium (2+).

The first metal to be applied in the ink preferably comprises palladium, copper, silver, gold, nickel, tin, iron or any combination thereof. More preferably, the first metal comprises palladium.

In step (c) the second metal is preferably deposited on the pattern of ink by means of a catalytic process which results in the precipitation of the second metal on the pattern of ink. Such a catalytic process can suitably be carried out by means of an electroless deposition process. In such electrolessdeposition, the driving force for the reduction of nickel metal ions and their deposition is supplied by a chemical reducing agent in solution. This driving potential will essentially be constant at all points of the surface of the component, provided the agitation will be sufficient to ensure a uniform concentration of metal ions and reducing agents

Preferably, in step (c) the second metal precipitates from a solution comprising a metal salt and/or an organometallic complex. Suitable examples
of metal salts and organometallic complexes are those mentioned hereinbefore.

The second metal to be used in step (c) preferably comprises (alloys of) nickel, copper, silver, gold, tin, any alloys thereof or any combination thereof. More preferably, the second metal comprises nickel or nickel alloys, such as nickel-boron and nickel-phosphorous, as well as copper.

The third metal to be used in step (d) preferably comprises copper, silver, gold, tin, nickel, any alloy thereof or any combination thereof. More preferably, the third metal comprises copper.

Depending on the condition of the surface of the non-conductive substrate layer, the substrate layer can directly be subjected to step (b) or the surface needs first to be modified to ensure that it displays sufficient wetting and/or adhesion properties so as to enable the ink to be applied onto the surface in an efficient and effective manner. Often the surface of the substrate layer will need to be modified before it can be subjected to step (b) according to the present invention. Hence, preferably the surface of the non-conductive substrate layer is modified in between steps (a) and (b). Preferably, the surface is modified by means a flame, corona, plasma, ozone, wet chemical, induction, laser beam, electron beam, ion implantation or cryo treatment or any combination of these treatments.

Preferably, the surface of the non-conductive substrate layer is modified in between steps (a) and (b) by means of a laser beam treatment.

Preferably, such laser beam treatment is performed at a dose in the range of from 1mJ/cm2 to 5J/cm2.

Preferably, such a laser beam treatment is performed at a pulse frequency in the range of 1 to 1000 Hz.

Preferably, the laser beam is produced when a pulse of high voltage electricity excites a mixture of gases including but not limited to argon, fluorine, helium, krypton, xenon and chloride.

Instead of modifying the surface of the non-conductive substrate layer by means of any of the above-mentioned modification treatments in order to bring about the required wetting and/or adhesion properties, one or more layers can be applied onto the surface of the substrate to obtain similar properties before step (b) is carried out. Such one or more layers may comprise comprise organic or polymer coatings, sol-gel films, films of surface active agents. In step (c) of the method according to the present invention, the pattern of ink can suitably be applied onto the surface of the substrate layer by means of any known inkjet printing technology or screen printing technology. Preferably, use is made of an inkjet printing technology. Such technologies are as such well known to the skilled person.

Suitably, the non-conductive substrate layer is provided with vias in between steps (a) and (b). This is especially attractive when the present method needs to be applied on both surfaces of the non-conductive substrate layer. Conductive devices wherein on both surfaces of the nonconductive substrate layer conductive tracks have been applied are especially attractive because of their conciseness.

The present invention therefore also relates to a method wherein steps (b)-(d) of the method according to the present invention are applied to both surfaces of the non-conductive substrate layer.

Preferably, the vias are provided in the non-conductive substrate layer by means of a laser treatment.

The non-conductive substrate layer can suitably be a polymer layer or a ceramic layer. Preferably, the non-conductive substrate layer comprises a polymer layer because then flexible conductive devices can be prepared. A further advantage of the present invention is the fact that the conductive device can be prepared at a low temperature because no fusing step is required, thus avoiding the use of elevated temperatures that will normally affect the structure and composition of a polymer layer.

Suitable examples of polymers of which the polymer substrate can be made include polyethylene terephthalates (PET), polyethylene naphthalates (PEN), polyethersulfones (PES), polycarbonates (PC), polybutylene terephthalates (PBT), polysulfones, phenolic resins, epoxy resins, polyesters, polyimides, polyetheresters, polyetheramides, cellulose acetates, aliphatic polyurethanes, polyacrylonitriles, polytetrafluoroethylenes, polyvinylidene fluorides, poly(methyl alpha-methacrylates) and aliphatic or cyclic polyolefins.

Preferred polymers include polyethylene terephthalates, polyethylene naphthalates, polybutylene terephthalates and polytetrafluoroethylenes.

Suitably, the polymer substrate can be reinforced with a hard coating. Suitable examples of hard coating include but are not limited to epoxy, polyurethane and acrylic coatings. Preferably, the hard coating is acrylic-based coating.

Further, the polymer to be used can suitable be filled or functionalised. Suitable fillers include talc, silica, barium sulfate, calcium sulfate, calcium carbonate, calcium silicate, iron oxides, mica, aluminum silicate, clay, glassfibers, carbon and mixtures thereof.

Suitable examples of ceramic materials of which the ceramic layer can be made include oxide ceramics, non-oxide ceramics, and ceramic-based composites. Preferably, the ceramic material comprises oxides or non-oxide composites.

Preferably, the ceramic material comprises polycrystalline alkaline earth metal titanate and an amount in the range of from 0.01 to 10% by weight of a hexavalent metal oxide, based on total ceramic material.

The present invention further relates to a conductive device obtainable by the method according to the present invention. Such a conductive device displays unique properties in terms of sharpness, straightness and narrowness of the track lines obtained on the surface of the device. Moreover, the conductive devices obtained in accordance with the present invention can contain a much larger amount of conductive tracks.

When the conductive device prepared in accordance with the present invention is a flexible conductive device wherein use is made of a non-conductive polymer substrate layer, the conductive device can attractively be used in tracking and tracing devices, telephone and automotive devices. In particular, for medical applications of sensors for human body fluids such as blood sugar level sensors can very attractively be produced with the method claimed.

One particularly interesting application is combining (by welding, gluing) the flexible metallised foil as made by the process claimed, with an aluminium plate providing an optimal heat sink system as is required for instance in parts generating a lot of heat in textile or ceramic. One application would be automotive headlamp lighting by using LEDs mounted on the conductive devices produced with the claimed method.

On the other hand, when use is made of non-conductive ceramic substrate layer, the conductive device prepared in accordance with the present invention can suitably be used in aeriels for mobile phones.

### Example

A film PET (Goodfellow, 0.175mm biaxially oriented) is used as a substrate to be partially metallised by the process claimed. The foil is on a continuous roll and has a thickness of 0.075 mm. One sheet of size 21cm by 29.5 cm is used as testsubstrate. However a roll to roll production line would also be possible

Holes are machined in the substrate using a suitable laser. For PET, this could be a laser operating at a wavelength where the absorption in the PET is high which could be either in the ultra-violet or the far infrared. In the ultraviolet suitable lasers would include excimer lasers, having a wavelengths of 157, 193 or 248nm (available from Lambda Physik, GSI group, GAM and others), or a frequency-converted solid-state lasers, with wavelengths around 266nm (4th harmonic) or 355nm (3rd harmonic) (available from Coherent, DPSS, Photonics Industries, JDSU Lightwave and others). In the infra-red, the 10.6mm (or better still the 9.4-9.6mm) radiation from the CO2 laser is suitable (available from Coherent, Synrad, GSI group and others). Alternatively, ultra-short pulse lasers, which have pulse durations from 1fs to 100ps (available from Coherent, Thales, Lumera, High-Q and others), can provide clean machining results through multi-photon interactions even thought he substrate is transparent to lower intensities at the laser wavelength.

The holes can be produced either in parallel or sequentially. The excimer laser, with its relatively high pulse energy (0.1 to 1J) but restricted repetition rate (10-100pps) is well suited to producing many holes simultaneously through by illuminating and imaging a mask which contains the desired hole pattern. The solid state lasers, with their smaller pulse energy (~1mJ) but high repetition rates (10-100,000 pps) are better suited to serial hole drilling where each hole is produced individually and then the beam move quickly (often using a galvo-scanner) to produce the next hole.

The substrate is corona treated on two sides using a home built corona treater that uses ionized air to increase the surface tension of nonporous substrates. The substrate is exposed to a discharge between a grounded and powered electrode at high voltage at a distance of 1 cm with a speed of 10 cm/sec. A low-frequency (typically 10-20 kHz) generator and a transformer usually provide the high voltage to the electrode. The applied voltage (20 kV peak), causing the atoms and molecules to become ionized and creating an atmospheric plasma discharge. The surface energy attained by this operation is decreased resulting in a good wetting behaviour of the water based ink.

The image of the conductive tracks to be is sent to the printer head controller, which is driving a Spectra Nova AAA 256 (Spectra is a trade name) printhead, was used to print a predescribed pattern of seeding ink onto the substrate. The printhead has 256 nozzles with native pitch of 90,91 dpi (dots per inch) and provides droplets 80-picoliter in size. The head can support a wide range of fluids (including aqueous inks) and is designed for a very long service life.

The printhead scans over the substrate and contactlessly prints the prescribed pattern of seed ink on the topside of the substrate. This may take several scans of the printhead in order to print the full surface of the substrate. Then the substrate is reversed and the bottom side is printed. In particular, it is noted that the holes get enough material also inside the pores to enable seeding in the through hole itself. The printer software provides the ability to print a variation of ink over the substrate.

For the seed ink, a solution was made by adding 20 ml Noviganth Aktivator AK1 (supplier Atotech NL B.V.) to a solution of 30 volume% of hydrochloric acid in water, is used.

After printing of both sides is completed, optionally an acceleration step is carried out by immersion of the foil in an oxalic acid solution (50 g/l). Successively, the ink is dried in a hot air station for 1 minute at 80C).

After drying, the electroless plating of a nickel layer with Enplate EN435 (supplier Enthone-OMI) is applied. After about 5 minutes, the electroless plating is stopped and the substrate is rinsed with water.

Then the substrate is taken to another bath with an electrolytic copper layer forming solution and a copper layer is deposited onto both sides of the substrate. The copper forming solution is a conventional copper sulphate/sulphuric acid bath that deposits copper at a rate of about 1 micron per minute on the tracks.

The flexible polymer substrate as received provides highly detailed copper tracks on both sides of the foil with conductive via connections from one side to the other.

## Claims

1. A method for preparing a conductive device comprising the steps of:
(a) providing a non-conductive substrate layer;
(b) applying a pattern of an ink on a surface of the substrate layer, which ink comprises a first metal;
(c) depositing a second metal on the ink pattern obtained in step (b); and
(d) applying a third metal on the second metal by means of electrodeposition.

2. A method according to claim 1, wherein the ink comprises metal particles and/or a metal composition suitable for electrolessdeposition.

3. A method according to claim 1 or 2, wherein the first metal comprises palladium, copper, silver, gold, nickel, tin or any combination thereof.

4. A method according to claim 3, wherein the first metal comprises palladium.

5. A method according to any one of claims 2-4, wherein the metal composition comprises a metal salt and/or an organometallic complex.

6. A method according to any one of claims 2-4, wherein the metal particles are metal nanoparticles.

7. A method according to any one of claims 1-5, wherein the second metal is deposited on the pattern of ink by means of a catalytic process resulting in the precipitation of the second metal on the pattern of ink.

8. A method according to claim 7, wherein the second metal precipitates from a solution comprising a metal salt and/or an organometallic complex.

9. A method according to any one of claims 1-7, wherein the second metal comprises nickel, copper, silver, gold, tin or any combination thereof.

10. A method according to claim 9, wherein the second metal comprises nickel.

11. A method according to any one of claims 1-10, wherein the third metal comprises copper, silver, gold, tin, aluminium or any combination thereof.

12. A method according to claim 10, wherein the third metal comprises copper.

13. A method according to any one of claims 1-12, wherein the surface of the substrate layer on which the pattern of ink is to be applied is modified in between steps (a) and (b) by means of a flame, corona, plasma, induction, laser beam, electron beam, ion implantation or cryo treatment, or any combination of these treatments.

14. A method according to claim 13, wherein the surface is modified by means of a laser beam treatment.

15. A method according to claim 14, wherein the leaser beam treatment is performed at a dose in the range of from 1mJ/cm² to 5J/cm².

16. A method according to claim 14 or 15, wherein the leaser beam treatment is performed at a pulse frequency in the range of from 1 to 1000 Hz.

17. A method according to any one of claims 1-17, wherein in step (b) the pattern of ink is applied on the surface of the substrate layer by means of an inkjet technology or a screen printing technology.

18. A method according to claim 17, wherein in step (b) the pattern of ink is applied on the surface of the substrate layer by means of an inkjet technology.

19. A method according to any one of claims claim 1-18, wherein the substrate layer is provided with vias in between steps (a) and (b).

20. A method according to claim 19, wherein the vias are provided with a laser treatment.

21. A method according to any one of claims 1-20, wherein the substrate layer is a polymer layer or a ceramic layer.

22. A method according to claim 21, wherein the substrate layer is a polymer layer.

23. A method according to claim 21 or 22, wherein the polymer is selected from the group consisting of polyethylene terephthalates, polyethylene naphthalates, polybutylene terephthalates and polytetrafluoroethylenes.

24. A method according to any one of claims 1-23, wherein steps (b)-(d) are applied to both surfaces of the substrate layer.

25. A conductive device obtainable by a method according to any one of claims 1-24.
